# EUROPÄISCHE PATENTSCHRIFT

(11) **EP 2 602 600 B1**
(45) Veröffentlichungstag und Bekanntmachung des Hinweises auf die Patenterteilung: **19.06.2019**
(21) Anmeldenummer: 12008174.0
(22) Anmeldetag: 06.12.2012
(51) Int. Cl.: G01L 9/00

(54) **Magnetischer Drucksensor**
Magnetic pressure sensor
Capteur de pression magnétique

(30) Priorität: 06.12.2011 DE 102011120166
(43) Veröffentlichungstag der Anmeldung: 12.06.2013
(73) Patentinhaber: TDK-Micronas GmbH, 79108 Freiburg (DE)
(72) Erfinder: Erdler, Gilbert, 76275 Ettlingen (DE)
(74) Vertreter: Koch Müller Patentanwaltsgesellschaft mbH

(56) Entgegenhaltungen:
- EP-A1- 2 322 906
- WO-A1-99/50633
- DE-C1- 3 129 224
- US-B1- 6 484 586

## Beschreibung

Die Erfindung betrifft einen magnetischen Drucksensor gemäß dem Oberbegriff des Patentanspruchs 1.

Aus der DE 195 10 365 A1 ist ein mechanisch elektrisches Wandlerelement bekannt. Hierbei wird mittels der Auslenkung einer Membran, welche eine magnetische Schicht aufweist, eine Hallspannung erzeugt. Die magnetische Schicht dient als Magnetfeldquelle. Ferner sind aus der WO 99 / 50 633 A1 der EP 2 322 906 A, und der DE 31 29 224 magnetische Drucksensoren bekannt.

Vor dem Hintergrund besteht die Aufgabe der Erfindung darin, einen magnetischen Drucksensor anzugeben, der den Stand der Technik weiterbildet.

Die Aufgabe wird durch einen magnetischen Drucksensor mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein magnetischer Drucksensor bereitgestellt, aufweisend einen Halbleiterkörper mit einer Oberseite und einer Rückseite und einen an der Oberseite des Halbleiterkörpers ausgebildeten Hallsensor und ein mit dem Halbleiterkörper verbundenes Distanzstück, wobei das Distanzstück in der Mitte eine Aussparung aufweist, sowie eine die Aussparung überdeckende Membran, wobei die Membran aus einem ersten Material besteht und einen ferromagnetischen Stoff umfasst, und der ferromagnetische Stoff eine magnetische Flussdichte einer außerhalb des ferromagnetischen Materials ausgebildeten Quelle konzentriert, und das Distanzstück als umlaufender Wall ausgebildet ist und aus einem zweiten Material besteht und das zweite Material von dem ersten Material in wenigstens einem Element unterschiedlich ist. Es sei angemerkt, dass der Hallsensor als sogenannter integrierter Hallsensor ausgebildet ist und hierdurch ein Teil des Halbleiterkörpers darstellt. Der Hallsensor ist derart an der Oberfläche ausgebildet, dass der Hallsensor von einer an der Oberfläche des Halbleiterkörpers ausgebildeten Passivierungsschicht vollständig bedeckt ist.

Des Weiteren sei angemerkt, dass die Membran bei einer Druckdifferenz zwischen der Oberfläche der Membran und der Rückfläche Membran, welche zu der Oberseite des Halbleiterkörpers zeigt, eine Auslenkung vollführt und eine Änderung der magnetischen Flussdichte und der Hallspannung bewirkt, indem die Membran den ferromagnetischen Stoff umfasst. Es sei des Weiteren angemerkt, dass der Wall bevorzugt in Form eines zylinderförmigen Rings ausgebildet ist. Des Weiteren sei angemerkt, dass der Hallsensor von dem Distanzstück oder von der Aussparung des Distanzstückes überdeckt wird.

Ein Vorteil der erfindungsgemäßen Vorrichtung ist es, dass sich ein einfacher und zuverlässiger integrierter Drucksensor herstellen lässt, der auf der Änderung einer lokalen magnetischer Flussdichte in Folge einer Bewegung bzw. einer Elongation der Membran beruht. Hierbei wird die Änderung der Flussdichte in dem Hallsensor als Änderung einer Hallspannung detektiert. Untersuchungen haben gezeigt, dass es vorteilhaft Ist, die Dicke der Schicht der Membran und die Größe der Membran an den zu messenden Druckbereich anzupassen. Hierbei wird für die Messung von großen Drücken ein dickere Membran und / oder einen kleineren Durchmesser der Membran gewählt. Es versteht sich, dass das Distanzstück mit der Oberseite des Halbleiterkörpers und der Membran einen abgeschlossenen und druckdichten Raum ausbilden und der Hallsensor auf der Oberseite des derart abgeschlossenen Raums abgeordnet ist. Insoweit bewirkt ein Unterschied des Druckes zwischen der Umgebung, d.h. also außerhalb des druckdichten Raums, und dem druckdichten Raum eine Elongation der Membran. Sinkt der Druck der Umgebung im Vergleich zu dem Druck des Raumes ab, wölbt sich die Membran nach außen d.h. in Richtung der Umgebung und vice versa.

Gemäß einer Weiterbildung besteht die Membran aus einer Mu-Metallschicht, wobei die Mu-Metallschicht vorzugsweise einlagig oder mehrlagig ausgebildet ist. In einer anderen bevorzugten Weiterbildung ist die Membran aus einem Verbundmaterial aufgebaut, wobei das Verbundmaterial vorzugsweise eine Polymerschicht umfasst. Es zeigt sich, dass sich in der Polymerschicht ferromagnetische Partikel einlagern lassen und eine geschlossene ferromagnetische Schicht ausbilden. Ein Vorteil des Verbundmaterials ist es, dass sich insbesondere mit einer Polymermembran eine größere Elastizität der Membran im Vergleich zu einer einlagigen dünnen Metallschicht erzielen lässt. Insbesondere lassen sich die elastischen Eigenschaften an den zu messenden Druckbereich anpassen. Hierbei weist die Membran für eine Messung von einem hohen Druck ein geringeres Elastizitätsmodul, d.h. die Membran ist steifer, als für die Messung von einem kleinen Druck auf.

Gemäß einer anderen Weiterbildung ist zwischen der Membran und dem Distanzstück eine Klebeschicht ausgebildet. Des Weiteren ist es bevorzugt, dass zwischen dem Distanzstück und dem Halbleiterkörper eine Klebeschicht ausgebildet ist. Ein Vorteil der Klebeschicht ist, dass sich eine zuverlässige und einfache Abdichtung sowohl zwischen der Membran und der Deckfläche des Distanzstücks als auch zwischen einer Unterseite des Distanzstücks und der Oberseite des Halbleiterkörpers ausbilden lässt. Gemäß einer bevorzugten Ausführungsform Ist zwischen einer Deckfläche des Distanzstückes und der Membran und zwischen einer Unterseite des Distanzstückes und der Oberseite des Halbleiterkörpers eine umlaufende doppelseitig mit dem Klebstoff beschichtete Folie ausgebildet. Die Folie lässt sich als streifenförmiger Kunststofffilm ausführen.

In einer anderen Weiterbildung besteht das Distanzstück aus einem Kunststoff, vorzugsweise aus einem photostrukturierbaren Polymer, insbesondere aus einem Polyimid oder einem SU8 Lack. Hierdurch lässt sich die Herstellung des Distanzstücks mittels eines photolithographischen Prozesses durchführen und In den Fertigungsprozess eines CMOS-Prozess vorteilhaft und kostengünstig integrieren. Gemäß einer anderen Ausführungsform enthält das Distanzstück ferromagnetische Stoffe. Ein Vorteil der ferromagnetischen Ausführung des Distanzstückes ist, dass sich der magnetische Schluss d.h. die Größe des magnetischen Flusses durch den Hallsensor gegenüber der Ausführung ohne ein ferromagnetisch ausgebildetes Distanzstück erhöht. Hierdurch wird die Änderung der Hallspannung bezogen auf eine vorgegeben Elongation vergrößert und die Sensitivität des Drucksensors erhöht. Durch die Verwendung von hartmagnetischen ferromagnetischen Werkstoffen als Füllmaterial und einer anschließenden Magnetisierung lässt sich das Distanzstück in einer Ausführung gemäß Anspruch 1 als ein Permanentmagnet ausführen. Ein Vorteil der vorgenannten Ausführungsform ist es, dass sich ein externer Magnet erübrigt und die Baugröße verringert wird.
Gemäß einer Weiterbildung wird der Wafer nach dem Aufbringen der Vielzahl von Distanzstücken vereinzelt und jeder Halbeleiterkörper auf einem Metall-träger angeordnet und gehäust.

Gemäß einer anderen Ausführungsform weist das Distanzstück an wenigstens einer Außenseite einen Steg auf. Vorzugsweise ist das Distanzstück mittels des Steges mit weiteren Distanzstücken verbunden. Untersuchungen haben gezeigt, dass sich eine Vielzahl von Distanzstücke, die mittels Stege miteinander verbunden sind, in einer Matrix anordnen lassen. Ein Vorteil ist, dass sich die Vielzahl von Distanzstücke in einem Arbeitsschritt auf einer sogenannten Leadframe Ebene auf der Oberseite auf einer Vielzahl von Halbleiterkörpern justiert anordnen lassen und ein aufwändiger Lithographieprozess zur Ausbildung des Distanzstückes entfällt.
Unter der Leadframe Ebene wird hierbei eine Vielzahl vereinzelter Halbleiterkörper verstanden, welche entsprechend der Matrix der Distanzstücke angeordnet sind. Gemäß einer Weiterbildung werden die Halbleiterkörper vereinzelt auf Leadframe Ebene gehäust und anschließend freigeschnitten. Nach der Ausbildung eines IC-Gehäuses ist ein Teil des Stegs an der Außenseite des IC-Gehäuses sichtbar.

Gemäß einer anderen Ausführungsform weist das Distanzstück bzw. der Wall anstelle eines ringförmigen einen im Wesentlichen rechteckigen Querschnitt und eine Höhe im Bereich von mindestens 20 µm bis maximal 1 mm aufweist.

In einer anderen Weiterbildung ist beabstandet von dem ersten Hallsensor ein zweiter im Halbleiterkörper integrierter Hallsensor vorgesehen. Hierdurch lassen sich die Hallspannungen beider Hallsensoren vergleichen und störende magnetische Gleichfelder weitestgehend eliminieren. Des Weiteren ist es in einer alternativen Ausführungsform bevorzugt, die Hallsensoren bezüglich des Erdmagnetfeldes unterschiedlich zueinander auszurichten und hierdurch unterschiedliche räumliche Komponenten der magnetischen Flussänderung in Folge einer Elongation der Membran zu detektieren.

Es ist bevorzugt, dass ein Metallträger mit mehreren Pins zur Aufnahme des Halbleiterkörpers vorgesehen ist. An der Oberseite des Halbleiterkörpers mehrere Metallflächen und eine integrierte Schaltung ausgebildet sind und die Pins mittels Bonddrähten mit den Metallflächen verbunden sind und zwischen dem Hallsensor und der integrierten Schaltung eine elektrische Wirkverbindung besteht und ein IC - Gehäuse vorgesehen ist und das IC-Gehäuse den Metallträger mit dem Halbleiterkörper und die Pins wenigstens teilweise aufnimmt, wobei die Pins teilweise aus dem IC - Gehäuse herausragen und das IC-Gehäuse eine Öffnung wenigstens in der Größe der Membran aufweist. Des Weiteren sind die Metallflächen mittels Leiterbahnen mit der integrierten Schaltung verschaltet.

In der Ausführungsform gemäß Anspruch 2, ist ein Permanentmagnet unterhalb des Halbleiterkörpers, vorzugsweise innerhalb eines einzigen gemeinsamen Gehäuses angeordnet. Untersuchungen haben gezeigt, dass es bevorzugt ist, der Abstand zwischen der Unterseite des Hableiterkörpers und dem Permanentmagnet weniger als 2 mm vorzugsweise weniger als 0.3 mm beträgt.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1a: eine Querschnittsansicht auf eine erfindungsgemäße Ausfüh-rungsform eines magnetischen Drucksensors,
- Figur 1b: eine Querschnittsansicht auf eine weitere erfindungsgemäße Ausführungsform eines magnetischen Drucksensors,
- Figur 2: eine Kennlinie des Verlaufs der Hallspannung über die Zeit für unterschiedliche Drücke,
- Figur 3: eine Draufsicht auf eine weitere Ausführungsform eines magnetischen Drucksensors,
- Figur 4: eine Querschnittsansicht auf eine erste gehäuste Ausführungsform,
- Figur 5: eine Querschnittsansicht auf eine zweite gehäuste Ausführungsform mit ein innerhalb des Gehäuses ausgebildeten Distanzstück als Permanentmagnet,
- Figur 6a: eine erste Ausschnittsdarstellung des Membran Gehäuseanschlusses der Ausführungsform der Figur 5,
- Figur 6b: eine zweite Ausschnittsdarstellung des Membran Gehäuseanschlusses der Ausführungsform der Figur 5,
- Figur 7: eine Draufsicht auf eine Ausführungsform des magnetischen Drucksensors mit seitlichen Streben an dem Distanzstück,
- Figur 8: eine Draufsicht auf eine gehäuste Ausführungsform des magnetischen Drucksensors der Figur 7.

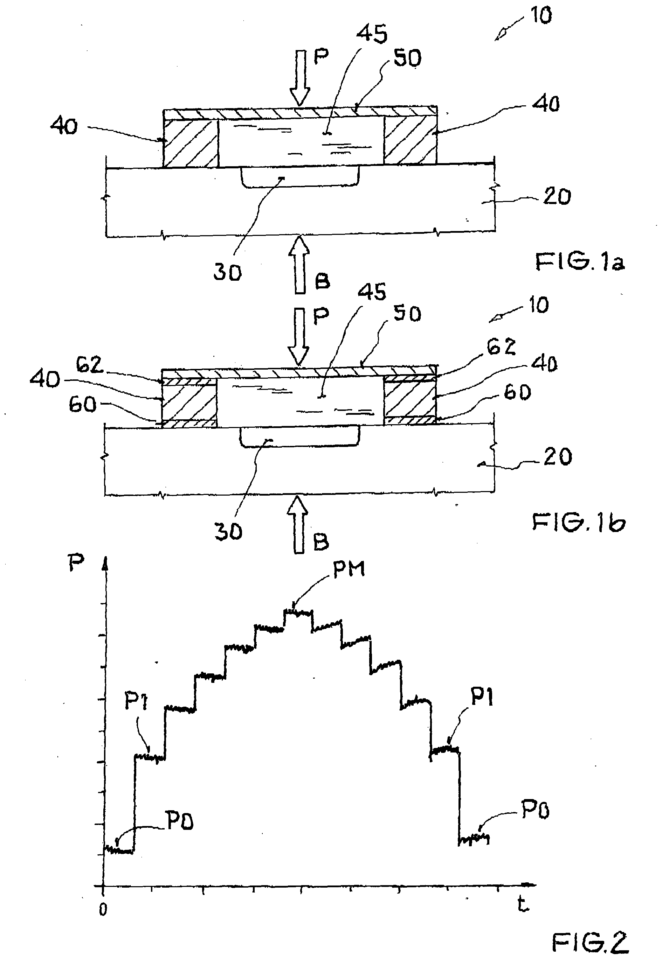

Die Abbildung der Figur 1 zeigt eine Querschnittsansicht eines erfindungsgemäßen magnetischen Drucksensors 10, aufweisend einen Halbleiterkörper 20 mit einer Oberseite und einer Rückseite, einen an der Oberseite des Halbleiterkörpers 20 ausgebildeten und in den Halbleiterkörper integrierten Hallsensor 30, ein mit dem Halbleiterkörper 20 verbundenes Distanzstück 40, wobei das Distanzstück 40 in der Mitte eine Aussparung 45 aufweist und eine die Aussparung 45 überdeckende Membran 50. Die Membran 50 besteht aus einem ersten Material und umfasst einen ferromagnetischen Stoff, wobei der ferromagnetische Stoff eine magnetische Flussdichte einer außerhalb des ferromagnetischen Materials ausgebildeten Quelle B konzentriert. Das Distanzstück 40 ist als umlaufender Wall ausgebildet und besteht aus einem zweiten Material, wobei das zweite Material sich von dem ersten Material in wenigstens einem Element unterscheidet. Die eine Unterseite des Distanzstückes 40 ist mit der Oberseite des Halbleiterkörpers 20 und die Membran 50 mit einer Deckfläche des Distanzstückes 40 verbunden. Das Distanzstück 40 bildet mit der Oberseite des Halbleiterkörpers 20 und der Membran 50 einen gasdichten Raum aus.

Der gasdichte Raum weist einen Innendruck von etwa einem Bar auf. Auf die Membran 50 drückt ein Umgebungsdruck P. In der dargestellten Ausführung ist die Membran in der Ruhelage, d.h. der Innendruck ist in etwa so groß wie der Umgebungsdruck. Ist der Umgebungsdruck P größer als der Innendruck ergibt sich aufgrund der Druckdifferenz eine resultierende Kraft und die Membran 50 wölbt sich nach innen in den gasdichten Raum. Hierbei wird die Anzahl der magnetischen Flusslinien, welche aus der näheren Umgebung des Hallsensors bzw. des Halbleiterkörpers durch die ferromagnetischen Membran 50, die vorzugsweise als Mu-Metallschicht ausgebildet ist, konzentriert sind, in dem Hallsensor geändert. Anders ausgedrückt, bei einer Wölbung nach Innen wird die Höhe des magnetischen Flusses in dem Hallsensor und hierdurch die Hallspannung vergrößert.

In der Figur 1b ist eine Draufsicht auf eine weitere Ausführungsform eines magnetischen Drucksensors dargestellt. Im Folgenden werden nur die Unterschiede zu den vorangegangenen Ausführungsformen erläutert. Zwischen der Unterseite des Distanzstückes 40 und der Oberseite des Halbleiterkörpers 20 ist eine erste Klebeschicht 60 ausgebildet. Zwischen der Deckfläche des Distanzstückes 40 und der Membran 50 ist eine zweite Klebeschicht 62 ausgebildet. Die erste Klebeschicht 60 und die zweite Klebeschicht 62 bilden mit dem Distanzstück 40, der Oberseite des Halbleiterkörpers 20 und der Membran 50 einen gasdichten Raum aus. Untersuchungen haben gezeigt, dass mit der Ausbildung der ersten Klebeschicht 60 und der zweiten Klebeschicht 62 sich eine besonders haltbare und gasdichte Ausführung ausbilden lässt. Hierbei werden insbesondere silikonhaltige Klebstoffe bevorzugt, Es sei angemerkt, dass gemäß einer alternativen Ausführungsform sich bei der Ausbildung des Distanzstückes mittels eines photolithographischen Prozesses die Ausbildung der ersten Klebeschicht erübrigt.

In der Figur 2 ist eine Kennlinie des Verlaufs einer Hallspannung IH über eine Zeit t für unterschiedliche Druckdifferenzen dargestellt Aufgrund eines äußeren magnetischen Feldes, beispielsweise einen Permanentmagneten - nicht dargestellt - und der bewirkten Hallspannung ergibt sich bereits bei Beginn der Messung eine Hallspannung, obwohl kein Differenzdruck anliegt. Wird nun ein erster Differenzdruck P1 ausgebildet, ergibt sich unmittelbar eine stufenförmige Erhöhung der Hallspannung. Wird der Umgebungsdruck in weiteren gleichmäßigen Stufen bis zu einem maximalen Differenzdruck PM gesteigert, erhöht sich auch die Hallspannung stufenförmig. Es zeigt sich, dass bei einer gleichmäßigen stufenförmigen Erhöhung des Umgebungsdrucks auch die Hallspannung sich stufenförmig erhöht. Jedoch wird bei der Hallspannung die Stufenhöhe mit zunehmendem Umgebungsdruck kleiner. Des Weiteren zeigt ausgehend von dem maximalen Umgebungsdruck bei einer stufenförmigen Abnahme hin zu einem Normaldruck also keinem Differenzdruck die Reversibilität des magnetischen Drucksensors.

Untersuchungen haben gezeigt, dass die Abnahme der Stufenhöhe bei einer Zunahme der Hallspannung im Wesentlichen in der abnehmenden Elongation der Membran 50 begründet ist. Indem der Raum unterhalb der Membran 50 gasdicht verschlossen ist, erhöht sich bei einer Innenwölbung der Membran der Innendruck des gasdicht verschlossenen Raums. Des Weiteren weist die Membran bei einer zunehmenden Elongation auch eine überproportionale Erhöhung in der Rückstellkraft auf. Beide Effekte verursachen eine abnehmende Stufenhöhe mit steigendem Druck.

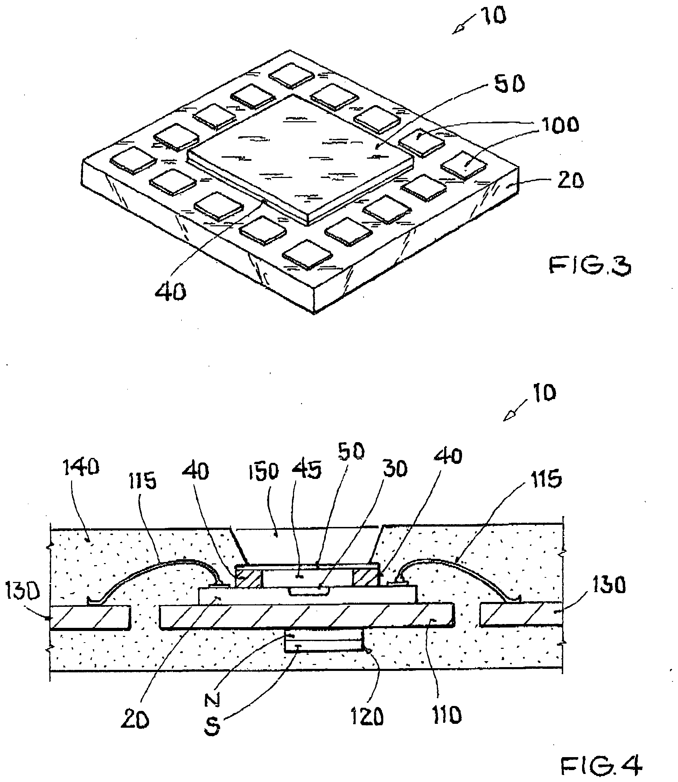

In der Figur 3 ist eine Draufsicht auf eine weitere Ausführungsform eines magnetischen Drucksensors dargestellt. Im Folgenden werden nur die Unterschiede zu den vorangegangenen Ausführungsformen erläutert. Auf der Oberseite des Halbleiterkörpers 20 weist das Distanzstück 40 eine quadratische Ausbildung aus und ist mit der Membran 50 vollständig überdeckt. An den Rändern des Halbleiterkörpers 20 sind Metallflächen 100 für einen elektrischen Anschluss einer nicht dargestellten integrierten Schaltung angeordnet. Die integrierte Schaltung ist des Weiteren mit dem Hallsensor 30 - nicht sichtbar - verschaltet.

In der Figur 4 ist eine Querschnittsansicht auf eine erste gehäuste Ausführungsform dargestellt. Im Folgenden werden nur die Unterschiede zu den vorangegangenen Ausführungsformen erläutert. Der Halbleiterkörper 20 ist einem Metallträger 110 mit mehreren Pins 130 angeordnet. Unterhalb des Metallträgers 110 ist ein Permanentmagnet 120 ausgebildet. Die Metallflächen 100 sind zur elektrischen Kontaktierung mittels Bonddrähte 115 mit Pins 130 verbunden. An der Oberseite des Halbleiterkörpers 20 ist eine nicht dargestellte integrierte Schaltung ausgebildet. Zwischen dem Hallsensor 30 und der integrierten Schaltung besteht eine elektrische Wirkverbindung mittels Leiterbahnen. Des Weiteren ist ein IC - Gehäuse 140 vorgesehen, wobei das IC-Gehäuse 140 den Metallträger 110 mit dem Halbleiterkörper 20, den Permanentmagneten 120 und die Pins 130 wenigstens teilweise aufnimmt und die Pins 130 teilweise aus dem IC - Gehäuse 140 herausragen. Ferner weist das IC-Gehäuse 140 eine sich in Richtung zu der Membran 50 verengende Öffnung 150 auf. Die Größe der Öffnung 150 beträgt wenigsten die Größe der Membran 50.

Der Permanentmagnet 120 weist einen Nordpol und einen Südpol auf. Der Halbleiterkörper 30 und der Permanentmagnet 120 sind derart in dem gleichen Gehäuse 70 angeordnet, dass die Feldlinien des Permanentmagneten 120 den Hallsensor 30 durchdringen. Es sei angemerkt, dass gemäß einer nicht dargestellten alternativen Ausführungsform der Permanentmagnet 120 anstelle der Integration in das IC - Gehäuse 140 außerhalb des IC- Gehäuses 140, vorzugsweise unterhalb des Metallträgers 110, angeordnet ist.

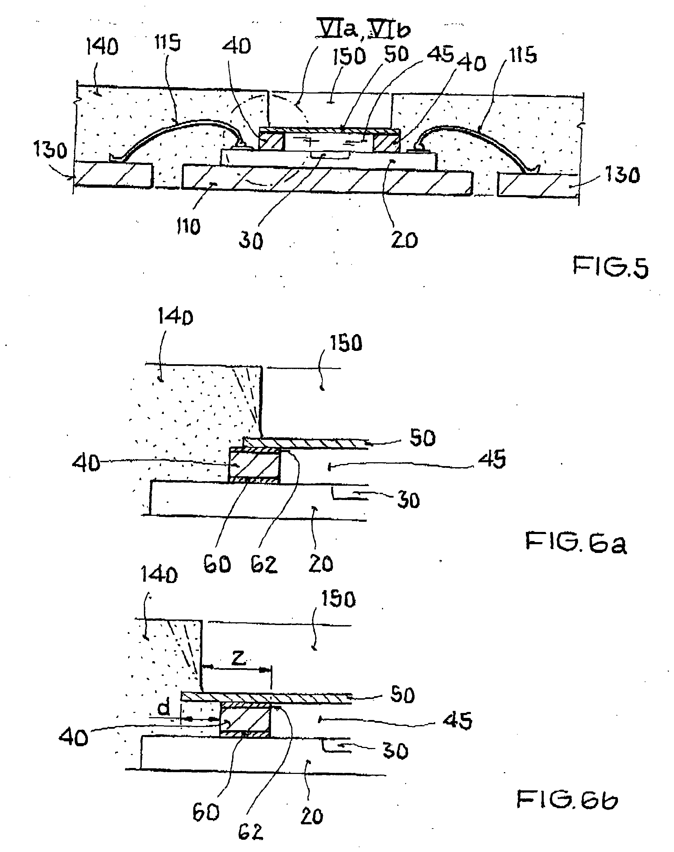

In der Figur 5 ist eine Querschnittsansicht auf eine zweite gehäuste Ausführungsform dargestellt. Im Folgenden werden nur die Unterschiede zu den vorangegangenen Ausführungsformen erläutert. Das IC-Gehäuse 140 umschließt die Metallträger 110 nur an einer Oberseite entsprechend der Ausbildung eines sogenannten QFN-Gehäuses. Das Distanzstück 40 ist als Permanentmagnet ausgebildet. Demgemäß erübrigt sich die Anordnung des Permanentmagneten 120. Des Weiteren weist die Öffnung 150 in dem gesamten Verlauf bis hin zu der Membran 50 einen einheitlichen Durchmesser auf.

In der Figur 6a und 6b ist eine erste Ausschnittsdarstellung bzw. eine zweite Ausschnittsdarstellung des Übergangs zwischen der Membran 50 und des Distanzstückes 40 der Abbildung der Figur 5 dargestellt. Im Folgenden werden nur die Unterschiede zu den vorangegangenen Ausführungsformen erläutert. Während in der Figur 6a die Membran 50 die Deckfläche des Distanzstückes nicht vollständig bedeckt, d.h. gegenüber dem äußeren Rand des Distanzstückes zurückgesetzt ist, wird in der Abbildung der Figur 6b der äußere Rand des Distanzstückes 40 an der Deckfläche von der Membran 50 um einen Abstand d vollständig überfahren. Des Weiteren ist in der Figur 6a das Gehäuse 140 gegenüber dem inneren Rand des Distanzstückes 40 zurückgesetzt, so dass das IC-Gehäuse 140 zwischen dem äußeren Rand und dem inneren Rand des Distanzstückes 40 beginnt. Demgegenüber beginnt in der Ausführungsform, dargestellt in der Abbildung der Figur 6b, das IC-Gehäuse 140 außerhalb des äußeren Rands des Distanzstückes 40. Ein Vorteil der letztgenannten Ausführungsform ist es, dass die Membran beidseitig mit dem Gehäuse 140 vorzugsweise stoffschlüssig verbunden ist. Hierdurch lässt sich die Membran besonders auch bei starken Bewegungen der Membran zuverlässig mit dem IC-Gehäuse 140 verbinden.

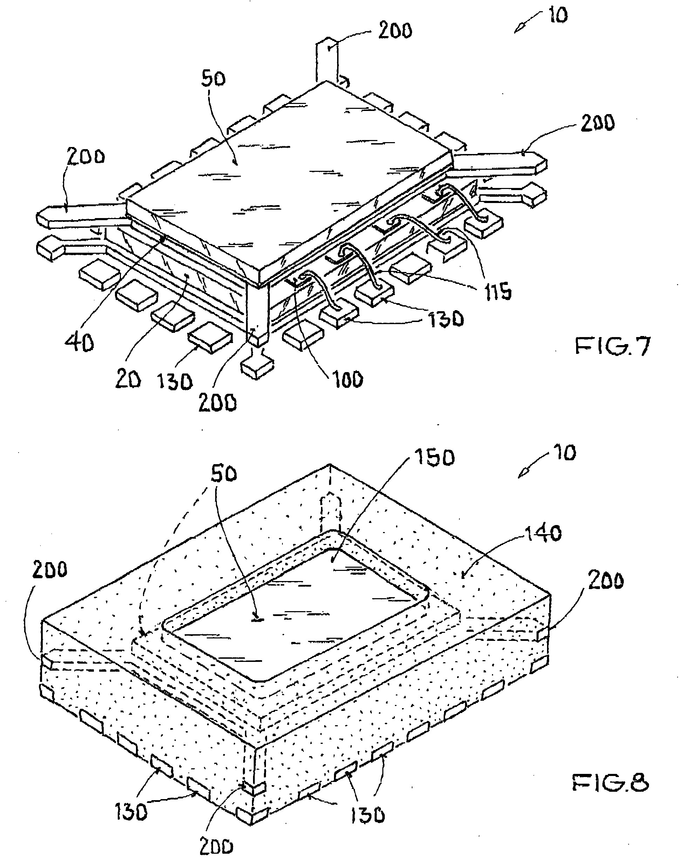

In der Figur 7 ist eine Draufsicht auf eine weitere Ausführungsform mit seitlichen Streben an dem Distanzstück dargestellt. Im Folgenden werden nur die Unterschiede zu den vorangegangenen Ausführungsformen erläutert. Das quadratische ausgebildete Distanzstück 40 weist jeweils an den vier Ecken Streben 200 auf. Die Streben 200 verbinden benachbarte Distanzstücke zu einer Matrix - nicht dargestellt. Hierdurch lässt sich auf nach dem Vereinzeln des Wafers mit einer Ausbildung einer Vielzahl von Halleiterkörpern auf einer Leadframe Ebene, eine entsprechend der Anordnung der Leadframes von einzelnen miteinander zu einer Matrix verbundenen Distanzstücke, mittels eines Justageschritts die Matrix auf der Anordnung der Leadframes positionieren. Ein Vorteil ist, dass sich eine Vielzahl von Materialien, insbesondere auch ferromagnetische Materialien für eine Ausbildung der Matrix verwenden lassen. Ferner lassen sich mit der Positionierung der Matrix erheblich Fertigungskosten gegenüber einer aufwändigen Einzelpositionierung einsparen.

In der Figur 8 ist eine Draufsicht auf eine gehäuste Ausführungsform des magnetischen Drucksensors der Figur 7 dargestellt. Im Folgenden werden nur die Unterschiede zu der Ausführungsform der Figur 7 erläutert. Das IC-Gehäuse 140 ist als QFN-Gehäuse ausgebildet. An den Außenseiten des IC-Gehäuses sind die Streben 200 teilweise sichtbar. Das IC-Gehäuse weist in der Mitte die Öffnung 150 auf. Die Öffnung 150 wird begrenzt durch die Membran 50 und durch das IC-Gehäuse 140.

## Patentansprüche

1. Magnetischer Drucksensor (10) aufweisend,
- ein Distanzstück (40) das in der Mitte eine Aussparung aufweist, und, das als umlaufender Wall ausgebildet ist,
- eine die Aussparung überdeckende Membran (50),
- eine außerhalb des ferromagnetischen Materials ausgebildete Quelle einer magnetischen Flussdichte, und
- einen Halbleiterkörper (20), der mit einer Oberseite und einer Rückseite vorgesehen ist, wobei das Distanzstück (40) mit dem Halbleiterkörper (20) verbunden ist,
**dadurch gekennzeichnet, dass**
- die Membran (50) aus einem ersten Material besteht und einen ferromagnetischen Stoff umfasst, und der ferromagnetische Stoff die magnetische Flussdichte der außerhalb des ferromagnetischen Materials ausgebildeten Quelle konzentriert,
das Distanzstück (40) aus einem zweiten Material besteht und das zweite Material von dem ersten Material in wenigstens einem Element unterschiedlich ist,
- der magnetische Drucksensor (10) einen an der Oberseite des Halbleiterkörpers (20) ausgebildeten integrierten Hallsensor (30) aufweist,
- der Hallsensor von einer an der Oberfläche des Halbleiterkörpers ausgebildeten Passivierungsschicht vollständig bedeckt ist und
- zwischen der Membran (50) und dem Distanzstück (40) eine Klebeschicht (62) ausgebildet ist, wobei
das Distanzstück (40) als Permanentmagnet ausgeführt ist.

2. Magnetischer Drucksensor (10) aufweisend,
ein Distanzstück (40) das in der Mitte eine Aussparung aufweist, und, das als umlaufender Wall ausgebildet ist,
- eine die Aussparung überdeckende Membran (50),
- eine außerhalb des ferromagnetischen Materials ausgebildete Quelle einer magnetischen Flussdichte, und
- einen Halbleiterkörper (20), der mit einer Oberseite und einer Rückseite vorgesehen ist, wobei das Distanzstück (40) mit dem Halbleiterkörper (20) verbunden ist,
wobei ein Permanentmagnet (120) unterhalb des Halbleiterkörpers (20) angeordnet ist.
**dadurch gekennzeichnet, dass**
- die Membran (50) aus einem ersten Material besteht und einen ferromagnetischen Stoff umfasst, und der ferromagnetische Stoff die magnetische Flussdichte der außerhalb des ferromagnetischen Materials ausgebildeten Quelle konzentriert,
das Distanzstück (40) aus einem zweiten Material besteht und das zweite Material von dem ersten Material in wenigstens einem Element unterschiedlich ist,
- der magnetische Drucksensor (10) einen an der Oberseite des Halbleiterkörpers (20) ausgebildeten integrierten Hallsensor (30) aufweist,
- der Hallsensor von einer an der Oberfläche des Halbleiterkörpers ausgebildeten Passivierungsschicht vollständig bedeckt ist und
- zwischen der Membran (50) und dem Distanzstück (40) eine Klebeschicht (62) ausgebildet ist, wobei.

3. Magnetischer Drucksensor (10) nach Anspruch 1 oder Anspruch 2, **dadurch gekennzeichnet, dass** die Membran aus einer einlagigen Mu-Metallschicht besteht.

4. Magnetischer Drucksensor (10) nach Anspruch 1 oder Anspruch 2, **dadurch gekennzeichnet, dass** die Membran (50) aus einem Verbundmaterial besteht und das Verbundmaterial eine Polymerschicht umfasst.

5. Magnetischer Drucksensor (10) nach Anspruch 2, **dadurch gekennzeichnet, dass** das Distanzstück (40) aus einem Kunststoff besteht.

6. Magnetischer Drucksensor (10) nach Anspruch 2, **dadurch gekennzeichnet, dass** das Distanzstück (40) ferromagnetische Stoffe enthält.

7. Magnetischer Drucksensor (10) nach einem der vorstehenden Ansprüche, **dadurch gekennzeichnet, dass** zwischen dem Distanzstück (40) und dem Halbleiterkörper (20) eine Klebeschicht (60) ausgebildet ist.

8. Magnetischer Drucksensor (10) nach einem der vorstehenden Ansprüche, **dadurch gekennzeichnet, dass** das Distanzstück (40) an wenigstens einer Außenseite einen Steg (200) aufweist.

9. Magnetischer Drucksensor nach Anspruch 8, **dadurch gekennzeichnet, dass** ein Teil des Stegs (200) an der Außenseite des IC-Gehäuses (140) sichtbar ist.

10. Magnetischer Drucksensor (10) nach einem der vorstehenden Ansprüche, **dadurch gekennzeichnet, dass** der Wall einen im Wesentlichen rechteckigen Querschnitt und eine Höhe im Bereich von mindestens 20 µm bis maximal 1 mm aufweist.

11. Magnetischer Drucksensor (10) nach einem der vorstehenden Ansprüche, **dadurch gekennzeichnet, dass** das Distanzstück (40) eine Deckfläche aufweist und zwischen der Deckfläche des Distanzstückes (40) und der Membran (50) eine umlaufende doppelseitig beschichtete Folie ausgebildet ist.

12. Magnetischer Drucksensor (10) nach einem der vorstehenden Ansprüche, **dadurch gekennzeichnet, dass** beabstandet von dem ersten Hallsensor (30) ein zweiter im Halbleiterkörper (20) integrierter Hallsensor vorgesehen ist.

13. Magnetischer Drucksensor nach Anspruch 2, **dadurch gekennzeichnet, dass**, der Abstand zwischen dem Hableiterkörper (20) und dem Permanentmagnet (120) weniger als 0.3 mm beträgt.

14. Magnetischer Drucksensor (10) nach einem der vorstehenden Ansprüche, **dadurch gekennzeichnet, dass** ein Metallträger (110) mit mehreren Pins zur Aufnahme des Halbleiterkörpers (20) vorgesehen ist und an der Oberseite des Halbleiterkörpers (20) mehrere Metallflächen (100) und eine integrierte Schaltung ausgebildet sind und die Pins (130) mittels Bonddrähten (115) mit den Metallflächen (100) verbunden sind und zwischen dem Hallsensor (30) und der integrierten Schaltung eine elektrische Wirkverbindung besteht und ein IC - Gehäuse (140) vorgesehen ist und das IC-Gehäuse (140) den Metallträger (110) mit dem Halbleiterkörper (20) und die Pins (130) wenigstens teilweise aufnimmt, wobei die Pins (130) teilweise aus dem IC - Gehäuse (140) herausragen und das IC-Gehäuse (140) eine Öffnung (150) wenigstens in der Größe der Membran (50) aufweist.

## Claims

1. Magnetic pressure sensor (10) comprising
- a spacer (40) which has a cut-out in the centre and is formed as an encircling wall,
- a membrane (50) covering the cut-out,
- a source, which is formed outside the ferromagnetic material, of a magnetic flux density and
- a semiconductor body (20) provided with an upper side and a rear side, wherein the spacer (40) is connected with the semiconductor body (20),
**characterised in that**
- the membrane (50) consists of a first material and comprises a ferromagnetic substance, and the ferromagnetic substance concentrates the magnetic flux density of the source formed outside the ferromagnetic material,
- the spacer (40) consists of a second material and the second material is different from the first material in at least one element,
- the magnetic pressure sensor (10) comprises an integrated Hall sensor (30) formed at the upper side of the semiconductor body (20),
- the Hall sensor is completely covered by a passivating layer formed at the surface of the semiconductor body and
- an adhesive layer (62) is formed between the membrane (50) and the spacer (40), wherein the spacer (40) is constructed as a permanent magnet.

2. Magnetic pressure sensor (10) comprising
- a spacer (40) which has a cut-out in the centre and is formed as an encircling wall,
- a membrane (50) covering the cut-out,
- a source, which is formed outside the ferromagnetic material, of a magnetic flux density and
- a semiconductor body (20) provided with an upper side and a rear side, wherein the spacer (40 is connected with the semiconductor body and wherein a permanent magnet (120) is arranged below the semiconductor body (20),
**characterised in that**
- the membrane (50) consists of a first material and comprises a ferromagnetic substance, and the ferromagnetic substance concentrates the magnetic flux density of the source formed outside the ferromagnetic material,
- the spacer (40) consists of a second material and the second material is different from the first material in at least one element,
- the magnetic pressure sensor (10) comprises an integrated Hall sensor (30) formed at the upper side of the semiconductor body (20),
- the Hail sensor is completely covered by a passivating layer formed at the surface of the semiconductor body and
- an adhesive layer (62) is formed between the membrane (50) and the spacer (40).

3. Magnetic pressure sensor (10) according to claim 1 or claim 2, **characterised in that** the membrane consists of a single-layered mu-metal layer.

4. Magnetic pressure sensor (10) according to claim 1 or claim 2, **characterised in that** the membrane (50) consists of a composite material and the composite material comprises a polymer layer.

5. Magnetic pressure sensor (10) according to claim 2, **characterised in that** the spacer (40) consists of a plastics material.

6. Magnetic pressure sensor (10) according to claim 2, **characterised in that** the spacer (40) includes ferromagnetic substances.

7. Magnetic pressure sensor (10) according to any one of the preceding claims, **characterised In that** an adhesive layer (60) is formed between the spacer (40) and the semiconductor body (20).

8. Magnetic pressure sensor (10) according to any one of the preceding claims, **characterised in that** the spacer (40) has a web (200) at at least one outer side.

9. Magnetic pressure sensor according to claim 8, **characterised in that** a part of the web (200) is visible at the outer side of the IC housing (140).

10. Magnetic pressure sensor (10) according to any one of the preceding claims, **characterised in that** the wall has a substantially rectangular cross-section and a height in the range of at least 20 microns to at most 1 millimetre.

11. Magnetic pressure sensor (10) according to any one of the preceding claims, **characterised in that** the spacer (40) has a top surface and an encircling film with double-sided coating is formed between the top surface of the spacer (40) and the membrane (50).

12. Magnetic pressure sensor (10) according to any one of the preceding claims, **characterised in that** a second integrated Hall sensor Is provided in the semiconductor body (20) at a spacing from the first Hall sensor (30).

13. Magnetic pressure sensor according to claim 2, **characterised in that** the spacing between the semiconductor body (20) and the permanent magnet (120) is less than 0.3 millimetres.

14. Magnetic pressure sensor (10) according to any one of the preceding claims, **characterised in that** a metal support (110) with several pins for reception of the semiconductor body (20) is provided, several metal surfaces (100) and an integrated circuit are formed at the upper side of the semiconductor body (20), the pins (130) are connected with the metal surfaces (100) by means of bonding wires (115), an electrically effective connection is present between the Hall sensor (30) and the integrated circuit, an IC housing (140) is provided and the IC housing (140) at least partly receives the metal support (110) with the semiconductor body (20) and the pins (130), wherein the pins (130) partly project out of the IC housing (140) and the IC housing (140) has an opening (150) at least of the size of the membrane (50).

## Revendications

1. Capteur de pression magnétique (10) présentant :
- une pièce d'écartement (40), qui présente au centre une découpe et qui est formée par un muret périphérique,
- une membrane (50) recouvrant la découpe,
- une source d'une densité de flux magnétique formée à l'extérieur du matériau ferromagnétique, et
- un corps semi-conducteur (20), qui est prévu avec un côté supérieur et un côté arrière, dans lequel la pièce d'écartement (40) est reliée au corps semi-conducteur (20),
**caractérisé en ce que**
- la membrane (50) se compose d'un premier matériau et comprend une substance ferromagnétique, et la substance ferromagnétique concentre la densité de flux magnétique de la source formée à l'extérieur du matériau ferromagnétique,
- la pièce d'écartement (40) se compose d'un second matériau et le second matériau est différent du premier matériau par au moins un élément,
- le capteur de pression magnétique (10) présente un capteur à effet Hall intégré (30) formé sur le côté supérieur du corps semi-conducteur (20),
- le capteur à effet Hall est entièrement recouvert par une couche de passivation formée sur la surface du corps semi-conducteur, et
- une couche de colle (62) est formée entre la membrane (50) et la pièce d'écartement (40),
dans lequel la pièce d'écartement (40) est un aimant permanent.

2. Capteur de pression magnétique (10) présentant :
- une pièce d'écartement (40), qui présente au centre une découpe et qui est formée par un muret périphérique,
- une membrane (50) recouvrant la découpe,
- une source d'une densité de flux magnétique formée à l'extérieur du matériau ferromagnétique, et
- un corps semi-conducteur (20), qui est prévu avec un côté supérieur et un côté arrière, dans lequel la pièce d'écartement (40) est reliée au corps semi-conducteur (20),
dans lequel un aimant permanent (120) est disposé en dessous du corps semi-conducteur (20),
**caractérisé en ce que**
- la membrane (50) se compose d'un premier matériau et comprend une substance ferromagnétique, et la substance ferromagnétique concentre la densité de flux magnétique de la source formée à l'extérieur du matériau ferromagnétique,
- la pièce d'écartement (40) se compose d'un second matériau et le second matériau est différent du premier matériau par au moins un élément,
- le capteur de pression magnétique (10) présente un capteur à effet Hall intégré (30) formé sur le côté supérieur du corps semi-conducteur (20),
- le capteur à effet Hall est entièrement recouvert par une couche de passivation formée sur la surface du corps semi-conducteur, et
- une couche de colle (62) est formée entre la membrane (50) et la pièce d'écartement (40).

3. Capteur de pression magnétique (10) selon la revendication 1 ou la revendication 2, **caractérisé en ce que** la membrane se compose d'une couche unique de mu-métal.

4. Capteur de pression magnétique (10) selon la revendication 1 ou la revendication 2, **caractérisé en ce que** la membrane (50) se compose d'un matériau composite et le matériau composite comprend une couche polymère.

5. Capteur de pression magnétique (10) selon la revendication 2, **caractérisé en ce que** la pièce d'écartement (40) se compose d'une matière plastique.

6. Capteur de pression magnétique (10) selon la revendication 2, **caractérisé en ce que** la pièce d'écartement (40) contient des substances ferromagnétiques.

7. Capteur de pression magnétique (10) selon l'une quelconque des revendications précédentes, **caractérisé en ce qu'**une couche de colle (60) est formée entre la pièce d'écartement (40) et le corps semi-conducteur (20).

8. Capteur de pression magnétique (10) selon l'une quelconque des revendications précédentes, **caractérisé en ce que** la pièce d'écartement (40) présente une nervure (200) sur au moins un côté extérieur.

9. Capteur de pression magnétique selon la revendication 8, **caractérisé en ce qu'**une partie de la nervure (200) est visible sur le côté extérieur du boîtier IC (140).

10. Capteur de pression magnétique (10) selon l'une quelconque des revendications précédentes, **caractérisé en ce que** le muret présente une section transversale essentiellement rectangulaire et une hauteur dans la plage d'au moins 20 µm à 1 mm au maximum.

11. Capteur de pression magnétique (10) selon l'une quelconque des revendications précédentes, **caractérisé en ce que** la pièce d'écartement (40) présente une face supérieure et une feuille périphérique à revêtement double face est formée entre la face supérieure de la pièce d'écartement (40) et la membrane (50).

12. Capteur de pression magnétique (10) selon l'une quelconque des revendications précédentes, **caractérisé en ce qu'**il est prévu un second capteur à effet Hall intégré dans le corps semi-conducteur (20) à distance du premier capteur à effet Hall (30).

13. Capteur de pression magnétique selon la revendication 2, **caractérisé en ce que** la distance entre le corps semi-conducteur (20) et l'aimant permanent (120) vaut moins de 0,3 mm.

14. Capteur de pression magnétique (10) selon l'une quelconque des revendications précédentes, **caractérisé en ce qu'**il est prévu un support métallique (110) avec plusieurs broches destiné à recevoir le corps semi-conducteur (20) et plusieurs faces métalliques (100) et un circuit intégré sont formés sur le côté supérieur du corps semi-conducteur (20) et les broches (130) sont reliées aux faces métalliques (100) au moyen de fils de liaison (115) et il existe une liaison électrique active entre le capteur à effet Hall (30) et le circuit intégré et il est prévu un boîtier IC (140) et le boîtier IC (140) contient au moins partiellement le support métallique (110) avec le corps semi-conducteur (20) et les broches (130), dans lequel les broches (130) font saillie partiellement hors du boîtier IC (140) et le boîtier IC (140) présente une ouverture (150) ayant au moins la grandeur de la membrane (50).
